# EUROPEAN PATENT SPECIFICATION

(11) **EP 4 452 022 B1**
(45) Date of publication and mention of the grant of the patent: **21.01.2026**
(21) Application number: 22840737.5
(22) Date of filing: 21.12.2022
(51) Int. Cl.: A47J 31/22

(54) **BEVERAGE PREPARATION WITH SIMPLE CAPSULE TRANSFER**
GETRÄNKEZUBEREITUNG MIT EINFACHEM KAPSELTRANSFER
PRÉPARATION DE BOISSON AVEC TRANSFERT DE CAPSULE SIMPLE

(30) Priority: 22.12.2021 EP 21216930
(43) Date of publication of application: 30.10.2024
(73) Proprietor: Société des Produits Nestlé S.A., 1800 Vevey (CH)
(72) Inventor: FANKHAUSER, Marcel, 3125 Toffen (CH); GAVILLET, Gilles, 1670 Ursy (CH); SCHENK, Rudolf, 3510 Konolfingen (CH)
(74) Representative: Schnyder, Frank Simon
(86) International application number: PCT/EP2022/087148
(87) International publication number: WO 2023/118247

(56) References cited:
- WO-A1-2015/173124
- WO-A1-2016/005417
- WO-A1-2021/122493
- WO-A2-2017/202746

## Description

### Field of the Invention

The field of the invention pertains to beverage preparation machines by centrifuging capsules containing an ingredient of the beverage to be prepared.

For the purpose of the present description, a "beverage" is meant to include any human-consumable liquid substance, such as tea, coffee, hot or cold chocolate, milk, soup, baby food, etc... A "capsule" is meant to include any container such as a packaging for containing a pre-portioned beverage ingredient, e.g. a flavouring ingredient, the packaging forming an enclosure of any material, in particular an airtight or pervious material, porous or non-porous material, e.g. plastic, aluminium, recyclable and/or biodegradable packagings, and of any shape and structure, including soft pods or rigid cartridges for containing the ingredient.

### Background Art

Certain beverage preparation machines use capsules containing ingredients to be extracted or to be dissolved and/or ingredients that are stored and dosed automatically in the machine or else are added at the time of preparation of the drink. Some beverage machines possess filling means that include a pump for liquid, usually water, which pumps the liquid from a source of water that is cold or indeed heated through heating means, e.g. a thermoblock or the like.

Especially in the field of coffee preparation, machines have been widely developed in which a capsule containing beverage ingredients is inserted in a brewing device. The brewing device is tightly closed about the capsule, water is injected at the first face of the capsule, the beverage is produced in the closed volume of the capsule and a brewed beverage can be drained from a second face of the capsule and collected into a receptacle such as a cup or glass.

Brewing devices have been developed to facilitate insertion of a "fresh" capsule and removal of the capsule upon use. Examples of such brewing devices are disclosed in EP 1 767 129, WO 2009/043630, WO 2005/004683 and WO 2007/135136. The preparation of a beverage by using centrifugation is also known. Examples of centrifugation processes and corresponding devices are disclosed in WO2008/148601, WO2008/148650, US 5,566,605, WO 2013/007776, WO 2013/007779 and WO 2013/007780.

Irrespectively of the extraction process itself it has also been proposed to facilitate the handling of capsules by systems for extracting them, in particular by motorizing the opening and/or closure of the extraction system for inserting and/or removing a capsule. Examples of such systems are for example disclosed in EP 1 767 129, WO2009/113035, WO 2012/025258, WO 2012/025259, WO 2012/041605, WO 2013/127476, WO 2014/096122, WO 2014/096123 and EP2015185946.9.

The preparation of a beverage by using centrifugation is also known. Such beverage preparation includes: providing a beverage (flavoring) ingredient, e.g. as powder and/or leaves, in a capsule; circulating liquid into the capsule and rotating the capsule at sufficient speed to ensure interaction of the liquid with the ingredient while creating a gradient of pressure of liquid in the capsule. Such pressure increases gradually from the centre towards the periphery of the capsule. As liquid traverses the ingredient, e.g. coffee bed, extraction of the ingredient, e.g. coffee compounds, takes place and a liquid extract is obtained that flows out at the periphery of the capsule. Examples of such systems are disclosed in WO2008/148601, WO 2013/007776, WO 2013/007779, WO 2013/007780, WO 2017/046294, WO 2017/068134 and WO 2017/202746.

It has been proposed to prepare beverages by centrifugation along a horizontal axis.

WO 2015/173123 and WO 2015/173124 disclose a centrifugal brewing chamber formed between two enclosing parts that are relatively translatable between an open position and a closed position. The enclosing parts cooperate with a pair of jaws that are movable between a capsule holding position to hold a capsule between the enclosing parts in the open position and a capsule release position to release the capsule. The jaws are actuated by a first actuator and a second actuator that are activated by the enclosing parts during their the relative translation. The jaws guide a capsule into a position between the enclosing parts in the open position and immobilize the capsule thereinbetween. Then, when the enclosing parts are translated together to enclose the capsule, the jaws release the capsule so that the brewing chamber is formed about the capsule. The enclosing parts are rotated about a horizontal axis to centrifuge the capsule for preparing the beverage with the ingredient in the capsule. At the end of beverage preparation, centrifugation stops and the enclosing parts are relatively translated to the open position whereby the used capsule is allowed to drop from the enclosing parts. Then the jaws are brought back into their capsule holding position.

### Summary of the Invention

The invention relates to a capsule processing machine for preparing a beverage from at least one ingredient. Normally such beverage is then dispensed to a user, e.g. to a user-cup or user-mug.

For instance, the machine is a coffee, tea, chocolate, cacao, milk or soup preparation machine. For example, the machine is arranged for preparing within a beverage processing module that includes the capsule holder, a beverage by passing hot or cold water or another liquid through a capsule held in the holder containing an ingredient, such as a flavouring ingredient, of the beverage to be prepared, such as ground coffee or tea or chocolate or cacao or milk powder.

Such beverage preparation typically includes the mixing of a plurality of beverage ingredients, e.g. water and milk powder, and/or the infusion of a beverage ingredient, such as an infusion of ground coffee or tea with water. One or more of such ingredients may be supplied in loose and/or agglomerate powder form and/or in liquid form, in particular in a concentrate form. A carrier or diluent liquid, e.g. water, may be mixed with such ingredient to form the beverage. Typically, a predetermined amount of beverage is formed and dispensed on user-request, which corresponds to a portion (e.g. a serving). The volume of such a serving may be in the range of 15 to 1000 ml such as 25 to 600 ml for instance 40 to 250 ml, e.g. the volume for filling a cup or mug, depending on the type of beverage. Formed and dispensed beverages may be selected from ristrettos, espressos, lungos, cappuccinos, café latte, americano coffees, teas, etc... For example, a coffee machine may be configured for dispensing espressos, e.g. an adjustable volume of 20 to 60 ml per serving, and/or for dispensing lungos, e.g. a volume in the range of 70 to 200 ml per serving, and/or for dispensing americanos, e.g. a volume in the range of 150 to 750 ml.

An aspect of the invention relates to a capsule processing machine for preparing a beverage from a capsule having a body containing an ingredient. The beverage is prepared by circulating a liquid into such capsule and centrifugally driving such capsule.

The centrifugation process for preparing a beverage is known for example from EP 2 000 062, EP 2 155 020, EP 2 152 128, WO 2008/148646, WO 2009/106175, WO 2009/106589, WO 2010/026045, WO 2010/026053, WO 2010/066736, WO 2008/148650, WO 2008/148834, WO 2010/066705, WO 2010/063644, WO 2011/023711, WO 2014/096122 or WO 2014/096123.

Typically, the machine includes one or more of the following components:
a) a fluid system in fluid communication with the capsule during beverage preparation;
b) an in-line heater and/or cooler for thermally conditioning a flow of liquid circulated into the capsule or a batch heater and/or cooler for circulating thermally conditioned liquid from the batch heater and/or cooler to the capsule;
c) a pump for pumping liquid to the capsule, in particular a low pressure pump e.g. within the range of 1 to 5 bar, such as 1.5 to 3 bar;
d) a motor for driving the capsule in rotation during beverage preparation;
e) an electric control unit, in particular comprising a printed circuit board (PCB), for receiving instructions from a user via an input user-interface and for controlling the heater and/or cooler, pump and motor(s); and
f) one or more sensors for sensing at least one characteristic selected from characteristics of fluid system, the heater and/or cooler, the pump, a liquid tank, an ingredient collector, a flow of the liquid (e.g. by a flowmeter), a pressure of the liquid and a temperature of the liquid, and for communicating such characteristic(s) to the control unit.

Typically, the capsule has a body containing an ingredient and a peripherally projecting flange, e.g. a body in the shape of a cup and a lid covering the mouth of the cup and extending beyond the mouth to form the peripherally projecting flange.

The capsule may have a body that is symmetric or asymmetric, conical or frusto-conical or cylindrical or spherical or hemispherical or frusto-spherical, containing the ingredient, e.g. ground coffee, tea or cacao or another beverage ingredient.

The capsule may be of the type described above under the header "field of the invention". The capsule may be a capsule that has a container-body, e.g. a generally cup-shaped or hemispherical or hemi-ellipsoidal body, having a flange to which a cover lid (or membrane) is attached, in particular sealed. Typically the capsule contains a beverage ingredient. Examples of suitable capsules are disclosed in WO 2008/148601, WO 2008/148604, WO 2008/148646, WO 2008/148650, WO 2008/148656, WO 2008/148834, WO 2011/141532, WO 2011/141535, WO 2013/072239, WO 2013/072297, WO 2013/072326, WO 2015/044400. The capsule may be of the variety commercialised by Nespresso under the brand Vertuo.

The machine has a first capsule handler and a second capsule handler that are movable one relative to the other from: a capsule transfer configuration for receiving the capsule by the first and second capsule handlers and/or releasing the capsule from the first and second capsule handlers; to a capsule processing configuration for centrifuging the capsule by rotation about a processing axis of the first and second capsule handlers; and vice versa.

The machine includes a capsule insertion passage associated with one or more capsule insertion guides configured to guide the capsule by guiding a projecting capsule flange of the capsule towards a capsule holding position in a space between the first and second capsule handlers in their transfer configuration. The space may be associated with a holding device, such as one or more stop members, e.g. stop members formed by or fixed to the insertion guide(s), configured to hold the capsule in the space prior to being held by at least one of the first and second capsule handlers relatively moving towards and/or into the capsule processing configuration. Suitable stop members are for example known from WO 2005/004683.

The machine has a machine frame and/or housing which is stationary when the first and second capsule handlers are rotated for centrifugation and which supports the first and second capsule handlers.

The frame and/or housing may include or be fixed to a bottom configured to rest on a support surface external to such machine when the first and second capsule handlers are rotated about the processing axis for centrifugation. The external support surface can be formed by a table top. The processing axis may be at a (positive or negative) angle relative to such bottom in the range of 0° to 80°, for instance of 0° to 45°, such as of 0° to 30°, e.g. of 0° to 15°, typically of substantially 0°.

The frame and/or housing can support a motor that is connected to at least one of the first and second capsule handlers. For instance, the motor is connected directly or via a transmission to the at least one of the support device, the first and second capsule handlers. Typically, such motor is connected by at least one of belts e.g. toothed belts, gears e.g. spur gears, and connecting rods, to the at least one of the support device, the first and second capsule handlers. Such motor can be configured to relatively move the first and second capsule handlers between their transfer and processing configurations and/or can be configured to rotate the first and second capsule handlers so as to centrifuge the capsule.

The capsule insertion guide(s) include(s) at least a rotatable portion that is stationary relative to at least one of the first and second capsule handlers and rotates therewith when the first and second capsule handlers are rotated for centrifugation. For example, the rotatable portion is formed by at least one of the first and second capsule handlers or is assembled thereto.

The capsule insertion guide(s) may have a non-rotatable portion that is stationary relative to the machine frame and/or housing when the first and second capsule handlers are rotated for centrifugation. For instance, the non-rotatable portion is stationary relative to the frame and/or housing when the first and second capsule handlers are relatively moved between the capsule transfer configuration and the capsule processing configuration. The non-rotatable portion may be formed by the machine frame and/or housing or being assembled thereto.

In such a configuration, the capsule insertion guide (or at least part thereof) is associated or integrated with the first or second rotatable handler. Hence, its mobility follows the mobility of the rotatable handler instead of forming a further entity in the system that requires proper mechanical and/or cinematic coordination with and dissociation from the rotatable handler.

The machine may include a handler support device for supporting the first and second capsule handlers.

The handler support device can be configured to be and remain angularly fixed relative to the first and second capsule handlers and to rotate therewith about the processing axis when the first and second capsule handlers are rotated for centrifugation.

The handler support device may be configured to be angularly fixed relative to the first and second capsule handlers in their transfer configuration.

Thus, the first and second capsule handlers and the capsule with the ingredient can be held by the rotating handler support and secured therein and rotate as a block. Hence the stress during the rotation resulting from imperfect alignment of the first and second capsule handlers and the capsule or its content between themselves and/or in relation with the processing axis and its effect on other parts of the machine may be minimised. For instance, stress of a closure force of the first and second capsule handlers about the capsule is not amplified by imperfect alignment of the first and second capsule handlers and the capsule or its content with the processing axis, especially at high rotational speed. This may conveniently lead to a reduction of vibrations during beverage preparation and wear of the machine, especially on bearing elements enabling the first and second capsule handlers to rotate in the machine. Avoiding vibrations due to imperfect alignment in parallel to rotations may also improve centrifugation of the capsule and ingredient processing inside the capsule.

The machine can include an actuator that is configured to actuate the first and/or second capsule handlers to relatively move the first and second capsule handlers between the capsule transfer and processing configurations. For instance, the actuator is connected to the machine frame and/or housing so as to remain stationary relative thereto when the first and second capsule handlers are rotated for centrifugation.

The actuator may include a motor or a handle pivotally mounted on a handle axis. The motor or the handle may cooperate with a translational transmission member, such as an actuator slide and/or a member controlled by the motor or the handle via a cam and cam follower connection. Such member may be directly or indirectly connected to the first and second capsule handlers for relatively moving the capsule handlers between the capsule transfer configuration and the capsule processing configuration.

The machine can include a driving device connected to the first and second capsule handlers to relatively move the capsule handlers between the capsule transfer configuration and the capsule processing configuration.

The driving device may be secured to the capsule handlers in the processing configuration by at least one of a lock, a friction stop and an over-centred lever or cam mechanism.

The driving device can include one or more of: levers e.g. levers assembled pivotally about pivoting axis in a knuckle joint arrangement; gears e.g. spur gears and/or racks e.g. spur racks; cams and cam followers; belts e.g. toothed belts; and driving slides.

The driving device may connect the first capsule handler and the second capsule handler via the handler support device. For instance, the first capsule handler or the second capsule handler is stationary relative to the handler support device, possibly fixed thereto or integral therewith.

The driving device may include the above driving slide(s), and optionally one or more transmission members connecting the driving slide(s) to the first and second capsule handlers, to relatively move the capsule handlers between the capsule transfer configuration and the capsule processing configuration. The driving slide(s) may be actuated by the abovementioned actuator, for instance by being connected to the abovementioned translational transmission member cooperating via a groove and pin with the driving slide(s).

The driving slide(s) can include a slide body bearing a pair of arms each delimiting a groove, the arms extending from the body in parallel or substantially in parallel to the processing axis along opposite sides of at least one of the first and second capsule handlers. For instance, the groove is delimited by a ridge or ledge projecting from the slide body, for example around the at least one of the first and second capsule handlers.

The first and second capsule handlers in their processing configuration may delimit a capsule processing chamber configured to enclose the capsule. For example, one capsule handler of the first and second capsule handlers forms a cavity shaped to receive the capsule and the other capsule handler of the first and second capsule handlers forms a lid configured to close the cavity in the processing configuration. The lid may be distant from the cavity in the transfer configuration, e.g. such as to provide sufficient space between the first and second capsule handlers for the capsule to be able to reach a position between the first and second capsule handlers in the transfer configuration and/or to be evacuated from such position.

At least one handler of the first and second capsule handlers may include or may be associated with an inlet for guiding a liquid carrier, e.g. water, to the capsule when the capsule is being centrifuged by rotation. For instance, the inlet is associated with a capsule inlet opener, e.g. an inlet piercing device, configured to open the capsule, such as a capsule opener that has a conduit for guiding the liquid carrier from the inlet into the capsule and/or a capsule opener that has an outer face delimiting a passage for guiding the liquid carrier from the inlet into the capsule.

At least one handler of the first and second capsule handlers can include or can be associated with an outlet for guiding the beverage from the capsule when the capsule is being centrifuged by rotation. For instance, the outlet is associated with a capsule outlet opener, e.g. an outlet piercing device, configured to open the capsule, such as a capsule opener that has a conduit for guiding the beverage from the capsule into the outlet and/or a capsule opener that has an outer face delimiting a passage for guiding the beverage from the capsule into the outlet.

One handler of the first and second capsule handlers may include or may be associated with both such inlet and outlet.

Examples of suitable outlets and inlets, e.g. leading into a beverage collector and then to a machine outlet, are disclosed in WO 2015/173123 and WO 2015/173124.

The capsule insertion passage can be covered by a lid or a gate when the first and second capsule handlers are rotated for centrifugation, e.g. when the first and second capsule handlers are in their capsule processing configuration. For instance, the lid or gate is formed by a or the abovementioned handle configured to relatively move the first and second capsule handlers between the capsule transfer and processing configurations.

The handler support device may be pivotally supported by the machine frame or housing via a first bearing, such as a ball or roller bearing or a magnetic or plain bearing, and via a second bearing, such as a second ball or roller bearing or a magnetic or plain bearing. The first and second bearings may be located spaced apart along the processing axis.

The first bearing can be located on a side of the handler support device that is closer to the first capsule handler than to the second capsule handler, the second bearing being located on a side of the support device that is closer to the second capsule handler than to the first capsule handler. The first and second bearings can be, e.g. located, at opposite ends of the support device.

The handler support device may have a substantially cylindrical shape extending along the processing axis and surrounding at least partly the first and second capsule handlers. For instance, the handler support device delimits one or two openings configured for passing the capsule into and/or out of the handler support device, e.g. via corresponding capsule inlet and/or outlet capsule passages, for example by passing the capsule transversally to the processing axis.

For instance, the capsules are collected in a capsule collector downstream the outlet capsule passage, as for example disclosed in WO 2009/074559 or WO 2009/135869.

The machine may have a positioning device configured to position at least one of the first and second capsule handlers at a predetermined angular position about the processing axis when the first and second capsule handlers are in the capsule transfer configuration, for instance when rotation of the first and second capsule handlers about the processing axis is at a stop.

The positioning device may have a mechanical position coupler, e.g. including a mechanical lock or stopper or break, such as a coupler that is uncoupled and/or deactivated during rotation of the first and second capsule handlers about the processing axis.

The positioning device can have a magnetic position coupler, such as a magnetic coupler having a connector stationary relative to the machine frame and/or housing. The stationary connector can be magnetically constrained with a connector that is fixed to or comprised by at least one of the first and second capsule handlers and the handler support device. For example, one connector of the connectors can be a magnetic field generating element, e.g. a permanent magnet or an electromagnet or a permanent magnet with an electromagnet configured to neutralize the permanent magnet when the first and second capsule handlers rotate about the processing axis, and the other connector of the connectors can have at least one of a ferromagnetic member, a permanent magnet and an electromagnet.

Another aspect of the invention relates to a system comprising a capsule processing machine as described above and a capsule having a body containing an ingredient. The capsule is handled by the capsule insertion guide(s) associated with the machine's capsule insertion passage, the rotatable portion of the insertion guide(s) being configured to rotate with the machine's first and second capsule handlers in their capsule processing configuration when the capsule is centrifuged.

A further aspect of the invention relates to a method of preparing in the above described machine a beverage from a capsule having a body containing an ingredient. The method comprises:
- transferring the capsule to the first and second capsule handlers in their transfer configuration to receive the capsule via the capsule insertion guide(s) associated with the capsule insertion passage;
- bringing the first and second capsule handlers into the capsule processing configuration; and
- centrifuging the capsule handled by the first and second capsule handlers that are rotated with the capsule insertion guide(s) about the processing axis and circulating the liquid into the capsule to form the beverage.

Yet another aspect of the invention relates to a use of a capsule as the capsule for: the above described machine; implementing the above described system; or carrying out the above described method. The capsule is provided to be:
- transferred to the first and second capsule handlers in their transfer configuration to receive the capsule via the capsule insertion guide(s) associated with the capsule insertion passage;
- supported by the first and second capsule handlers in their capsule processing configuration; and
- centrifuged while being handled by the first and second capsule handlers that are rotated with the capsule insertion guide(s) about the processing axis while the liquid is circulated into the capsule to form the beverage.

### Brief Description of the Drawings

The invention will now be described with reference to the schematic drawings, wherein:
- Figure 1 is a cross-sectional side view of part of a machine in a capsule transfer configuration and a capsule insertion guide that has a rotatable portion according to the invention;
- Figure 2 is a cross-sectional view from above of part of the machine shown in Fig. 1;
- Figure 3 is a cross-sectional side view of part of the machine shown in Fig. 1 after it has been brought into the capsule processing configuration; and
- Figure 4 is a cross-sectional view from above of part of the machine shown in Fig. 1.

### Detailed description

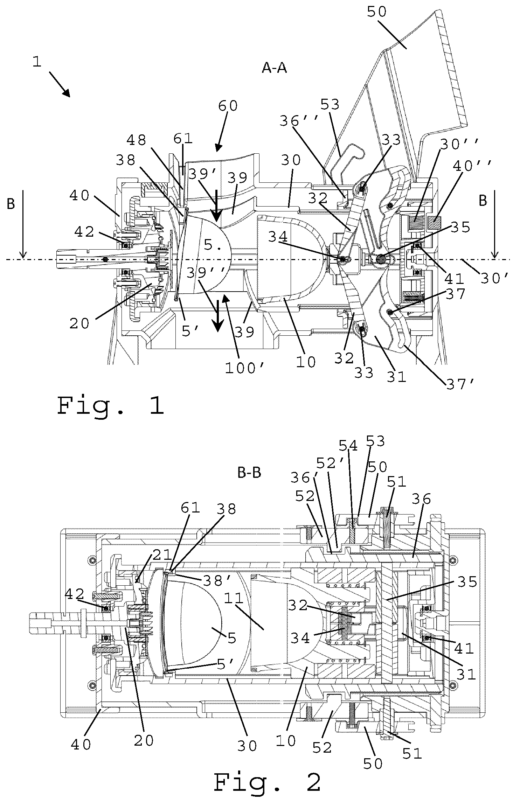

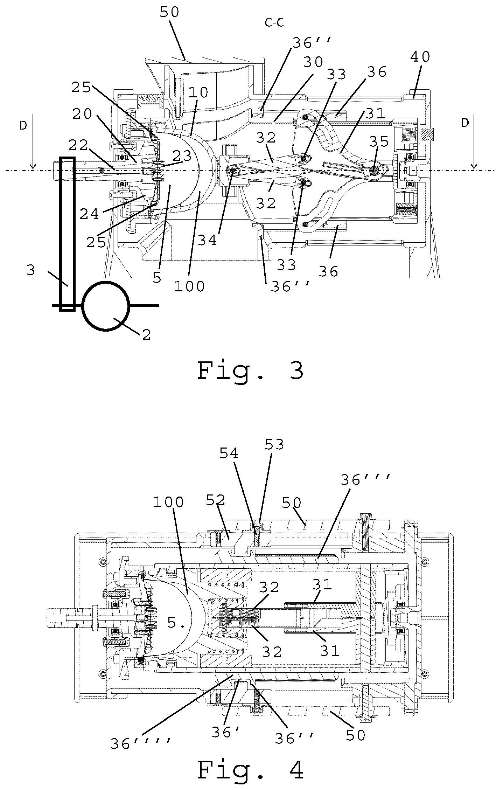

Figures 1 to 4 illustrate an exemplary embodiment of a machine 1 handling an ingredient capsule 5 having a body containing an ingredient, in accordance with the invention.

Beverage may be prepared by using machine 1 for instance by circulating a liquid, e.g. water such as thermally conditioned water, into capsule 5 and centrifugally driving capsule 5.

Machine 1 has a first capsule handler 10 and a second capsule handler 20 that are movable one relative to the other from:
- a capsule transfer configuration for receiving capsule 5 by first and second capsule handlers 10,20 and/or releasing capsule 5 from first and second capsule handlers 10,20; to
- a capsule processing configuration for centrifuging capsule 5 by rotation about a processing axis 30' of first and second capsule handlers 10,20; and
- vice versa.

Machine 1 includes a capsule insertion passage 60 associated with one or more capsule insertion guides 61 configured to guide a projecting capsule flange 5' of capsule 5, towards a capsule holding position in a space 100' between first and second capsule handlers 10,20 in their transfer configuration. For example, space 100' is associated with a holding device, such as one or more stop members 38' e.g. stop members 38' formed by or fixed to insertion guide(s) 61, configured to hold capsule 5 in space 100' prior to being held by at least one of first and second capsule handlers 10,20 relatively moving towards and/or into the capsule processing configuration.

Machine 1 is provided with a machine frame and/or housing 40 which is stationary when first and second capsule handlers 10,20 are rotated for centrifugation and which supports first and second capsule handlers 10,20.

Frame and/or housing 40 may include or be fixed to a bottom configured to rest on a support surface external to such machine 1 when first and second capsule handlers 10,20 are rotated about processing axis 30' for centrifugation, e.g. an external support surface formed by a table top. Processing axis 30' can be at an angle relative to such bottom in the range of 0° to 80°, for instance of 0° to 45°, such as of 0° to 30°, e.g. of 0° to 15°, typically of substantially 0°.

Frame and/or housing 40 may support a motor 2 that is connected to at least one of first and second capsule handlers 10,20, for instance connected directly or via a transmission 3 such as at least one of belts e.g. toothed belts, gears e.g. spur gears, and connecting rods.

Capsule insertion guide(s) 61 include(s) at least a rotatable portion 38 that is stationary relative to at least one of first and second capsule handlers 10,20 and rotates therewith when first and second capsule handlers 10,20 are rotated for centrifugation. For example, rotatable portion 38 is formed by first and/or second capsule handlers 10,20 or is assembled thereto.

Capsule insertion guide(s) 61 may include a non-rotatable portion 48 that is stationary relative to machine frame and/or housing 40 when first and second capsule handlers 10,20 are rotated for centrifugation. For example, non-rotatable portion 48 is stationary relative to frame and/or housing 40 when first and second capsule handlers 10,20 are relatively moved between the capsule transfer configuration and the capsule processing configuration, e.g. non-rotatable portion 48 being formed by machine frame and/or housing 40 or being assembled thereto.

Machine 1 can have a handler support device 30 for supporting first and second capsule handlers 10,20.

Handler support device 30 may be configured to be and remain angularly fixed relative to first and second capsule handlers 10,20 and to rotate therewith about processing axis 30' when first and second capsule handlers 10,20 are rotated for centrifugation. For example, handler support device 30 is configured to be angularly fixed relative to the first and second capsule handlers 10,20 in their transfer configuration.

Machine 1 may include an actuator 50,51,52 that is configured to actuate first and/or second capsule handlers 10,20 to relatively move first and second capsule handlers 10,20 between the capsule transfer and processing configurations. For instance, actuator 50,51,52 is connected to machine frame and/or housing 40 so as to remain stationary relative thereto when first and second capsule handlers 10,20 are rotated for centrifugation.

The actuator can include a motor or a handle 50 that is pivotally mounted on a handle axis 51, the motor or handle 50 cooperating with a translational transmission member 52, such as an actuator slide 52 and/or a member 52 controlled by the motor or handle 50 via a cam 53 and cam follower 54 connection, directly or indirectly connected to first and second capsule handlers 10,20 for relatively moving capsule handlers 10,20 between the capsule transfer configuration and the capsule processing configuration.

Machine 1 may include a driving device 31,32,32,33,34,35,36 connected to first and second capsule handlers 10,20 to relatively move capsule handlers 10,20 between the capsule transfer configuration and the capsule processing configuration.

Driving device 31,32,32,33,34,35,36 may secure capsule handlers 10,20 in the processing configuration by at least one of a lock, a friction stop and an over-centred lever or cam mechanism 37,37'.

Driving device 31,32,32,33,34,35,36 can include one or more of: levers 31,32 e.g. levers assembled pivotally about pivoting axis 33,34,35 in a knuckle joint arrangement; gears e.g. spur gears and/or racks e.g. spur racks; cams and cam followers; belts e.g. toothed belts; and driving slides 36.

Driving device 31,32,32,33,34,35,36 may connect first capsule handler 10 and second capsule handler 20 via handler support device 30. For instance, the first capsule handler or second capsule handler 20 is stationary relative to handler support device 30.

Driving device 31,32,33,34,35,36 may include the abovementioned driving slide(s) 36, and optionally one or more transmission members 31,32,33,34,35 connecting driving slide(s) 36 to first and second capsule handlers 10,20, to relatively move capsule handlers 10,20 between the capsule transfer configuration and the capsule processing configuration. Driving slide(s) 36 can be actuated by the abovementioned actuator 50,51,52, for instance by being connected to the abovementioned translational transmission member 52 cooperating via a groove 36' and pin 52' with driving slide(s) 36.

Driving slide(s) 36 can have a slide body 36‴ bearing a pair of arms 36ʺʺ each delimiting a groove 36', arms 36ʺʺ extending from body 36‴ in parallel or substantially in parallel to processing axis 30' along opposite sides of at least one of first and second capsule handlers 10,20. For example, groove 36' is delimited by a ridge or ledge 36'' projecting from slide body 36‴ e.g. around the at least one of the first and second capsule handlers 10,20.

First and second capsule handlers 10,20 in their processing configuration may delimit a capsule processing chamber 100 configured to enclose capsule 5. For example, one capsule handler 10 of first and second capsule handlers 10,20 forms a cavity 11 shaped to receive capsule 5 and the other capsule handler 20 of first and second capsule handlers 10,20 forms a lid 21 configured to close cavity 11 in processing configuration to secure capsule 5 in cavity 11, lid 21 being distant from cavity 11 in the transfer configuration, e.g. such as to provide sufficient space 100' between first and second capsule handlers 10,20 for capsule 5 to be able to reach a position between first and second capsule handlers 10,20 in the transfer configuration and/or to be evacuated from such position.

At least one handler 20 of first and second capsule handlers 10,20 may include or may be associated with an inlet 22 for guiding a liquid carrier, e.g. water, to capsule 5 when capsule 5 is being centrifuged by rotation. For example, inlet 22 is associated with a capsule inlet opener, e.g. an inlet piercing device 23, configured to open capsule 5. The capsule opener can have a conduit for guiding the liquid carrier from inlet 22 into capsule 5. The capsule opener may have an outer face delimiting a passage for guiding the liquid carrier from the inlet into capsule.

At least one handler 20 of first and second capsule handlers 10,20 can include or be associated associated with an outlet 24 for guiding the beverage from capsule 5 when capsule 5 is being centrifuged by rotation. For example, outlet 24 is associated with a capsule outlet opener, e.g. an outlet piercing device 25, configured to open capsule 5. The capsule opener may have a conduit for guiding the beverage from the capsule into the outlet. The capsule opener can have an outer face delimiting a passage for guiding the beverage from the capsule into the outlet.

One handler 20 of first and second handlers 10,20 may include or being associated with both such inlet 22 and outlet 24.

Capsule insertion passage 60 may be covered by a lid or a gate when first and second capsule handlers 10,20 are rotated for centrifugation, e.g. when first and second capsule handlers 10,20 are in their capsule processing configuration. For example, the lid or gate is formed by a or the abovementioned handle 50 configured to relatively move first and second capsule handlers 10,20 between the capsule transfer and processing configurations.

Handler support device 30 can be pivotally supported by machine frame or housing 40 via a first bearing 41, such as a ball or roller bearing or a magnetic or plain bearing, and via a second bearing 42, such as a second ball or roller bearing or a magnetic or plain bearing. First and second bearings 41,42 may be located spaced apart along processing axis 30'.

First bearing 41 can be located on a side of handler support device 30 that is closer to the first capsule handler 10 than to second capsule handler 20. Second bearing 42 can be located on a side of support device 30 that is closer to second capsule handler 20 than to first capsule handler 10. For example, first and second bearings 41,42 are, e.g. located, at opposite ends of handler support device 30.

Handler support device 30 can have a substantially cylindrical shape extending along processing axis 30' and surrounding at least partly first and second capsule handlers 10,20. For example, handler support device 30 delimits one or two openings 39 configured for passing capsule 5 into and/or out of handler support device 30 e.g. via corresponding capsule inlet and/or outlet capsule passages 39',39". For instance, capsule 5 is passed transversally to processing axis 30'.

Machine 1 can have a positioning device 30",40" configured to position at least one of the first and second capsule handlers 10,20 at a predetermined angular position about processing axis 30' when first and second capsule handlers 10,20 are in the capsule transfer configuration, for instance when rotation of first and second capsule handlers 10,20 about the processing axis 30' is at a stop.

Positioning device 30",40" may include a mechanical position coupler, e.g. including a mechanical lock or stopper or break, such as a coupler that is uncoupled and/or deactivated during rotation of first and second capsule handlers 10,20 about processing axis 30'.

Positioning device 30",40" can be provided with a magnetic position coupler, such as a magnetic coupler having a connector 40" stationary relative to machine frame and/or housing 40. Stationary connector 40" can be magnetically constrained with a connector 30" that is fixed to or included in at least one of first and second capsule handlers 10,20 and handler support device 30. One connector 40" of connectors 30",40" may be a magnetic field generating element, e.g. a permanent magnet or an electromagnet or a permanent magnet with an electromagnet configured to neutralize the permanent magnet when first and second capsule handlers 10,20 rotate about processing axis 30'. The other connector 30" of connectors 30",40" may include at least one of a ferromagnetic member, a permanent magnet and an electromagnet.

## Claims

1. A capsule processing machine (1) for preparing a beverage from a capsule (5) having a body containing an ingredient by circulating a liquid into such capsule (5) and centrifugally driving such capsule (5), comprising:
- a first capsule handler (10) and a second capsule handler (20) that are movable one relative to the other from:
- a capsule transfer configuration for receiving said capsule (5) by the first and second capsule handlers (10,20) and/or releasing said capsule (5) from the first and second capsule handlers (10,20); to
- a capsule processing configuration for centrifuging said capsule (5) by rotation about a processing axis (30') of the first and second capsule handlers (10,20); and
- vice versa;
- a capsule insertion passage (60) associated with one or more capsule insertion guides (61) configured to guide said capsule (5) by guiding a projecting capsule flange (5') of said capsule (5) towards a capsule holding position in a space (100') between the first and second capsule handlers (10,20) in their transfer configuration, for instance the space (100') being associated with a holding device, such as one or more stop members (38') e.g. stop members (38') formed by or fixed to the insertion guide(s) (61), configured to hold said capsule in the space (100') prior to being held by at least one of the first and second capsule handlers (10,20) relatively moving towards and/or into the capsule processing configuration,
- a machine frame and/or housing (40) which is stationary when the first and second capsule handlers (10,20) are rotated for centrifugation and which supports the first and second capsule handlers (10,20),
optionally the frame and/or housing:
- comprising or being fixed to a bottom configured to rest on a support surface external to such machine (1) when the first and second capsule handlers (10,20) are rotated about the processing axis (30') for centrifugation, e.g. an external support surface formed by a table top, the processing axis (30') being at an angle relative to such bottom in the range of 0° to 80°, for instance of 0° to 45°, such as of 0° to 30°, e.g. of 0° to 15°, typically of substantially 0°; and/or
- supporting a motor (2) that is connected to at least one of the first and second capsule handlers (10,20), for instance connected directly or via a transmission (3) such as at least one of belts e.g. toothed belts, gears e.g. spur gears, and connecting rods,
**characterised in that** the capsule insertion guide(s) (61) comprise(s) at least a rotatable portion (38) that is stationary relative to at least one of the first and second capsule handlers (10,20) and rotates therewith when the first and second capsule handlers (10,20) are rotated for centrifugation, optionally the rotatable portion (38) being formed by at least one of the first and second capsule handlers (10,20) or being assembled thereto.

2. The machine of claim 1, wherein the capsule insertion guide(s) (61) comprise(s) a non-rotatable portion (48) that is stationary relative to the machine frame and/or housing (40) when the first and second capsule handlers (10,20) are rotated for centrifugation, optionally the non-rotatable portion (48) being stationary relative to the frame and/or housing (40) when the first and second capsule handlers (10,20) are relatively moved between the capsule transfer configuration and the capsule processing configuration, e.g. the non-rotatable portion (48) being formed by the machine frame and/or housing (40) or being assembled thereto.

3. The machine of any preceding claim, which comprises a handler support device (30) for supporting the first and second capsule handlers (10,20), the handler support device (30) being configured to be and remain angularly fixed relative to the first and second capsule handlers (10,20) and to rotate therewith about the processing axis (30') when the first and second capsule handlers (10,20) are rotated for centrifugation, optionally the handler support device (30) being configured to be angularly fixed relative to the first and second capsule handlers (10,20) in their transfer configuration.

4. The machine of any preceding claim, which comprises an actuator (50,51,52) that is configured to actuate the first and/or second capsule handlers (10,20) to relatively move the first and second capsule handlers (10,20) between the capsule transfer and processing configurations, optionally the actuator (50,51,52) being connected to the machine frame and/or housing (40) so as to remain stationary relative thereto when the first and second capsule handlers (10,20) are rotated for centrifugation,
for instance, the actuator comprising a motor or a handle (50) pivotally mounted on a handle axis (51), the motor or the handle (50) cooperating with a translational transmission member (52), such as an actuator slide (52) and/or a member (52) controlled by the motor or the handle (50) via a cam (53) and cam follower (54) connection, directly or indirectly connected to the first and second capsule handlers (10,20) for relatively moving the capsule handlers (10,20) between the capsule transfer configuration and the capsule processing configuration.

5. The machine of any preceding claim, which comprises a driving device (31,32,32,33,34,35,36) connected to the first and second capsule handlers (10,20) to relatively move the capsule handlers (10,20) between the capsule transfer configuration and the capsule processing configuration, optionally the driving device (31,32,32,33,34,35,36):
- securing the capsule handlers (10,20) in the processing configuration by at least one of a lock, a friction stop and an over-centred lever or cam mechanism (37,37'); and/or
- comprising one or more of: levers (31,32) e.g. levers assembled pivotally about pivoting axis (33,34,35) in a knuckle joint arrangement; gears e.g. spur gears and/or racks e.g. spur racks; cams and cam followers; belts e.g. toothed belts; and driving slides (36).

6. The machine of claim 5 when depending on claim 3, wherein the driving device (31,32,32,33,34,35,36) connects the first capsule handler (10) and the second capsule handler (20) via the handler support device (30), for instance the first capsule handler or the second capsule handler (20) being stationary relative to the handler support device (30).

7. The machine of claim 5 or 6 when depending on claim 3 or 4, wherein the driving device (31,32,33,34,35,36) comprises said driving slide(s) (36), and optionally one or more transmission members (31,32,33,34,35) connecting the driving slide(s) (36) to the first and second capsule handlers (10,20), to relatively move the capsule handlers (10,20) between the capsule transfer configuration and the capsule processing configuration, the driving slide(s) (36) being actuated by said actuator (50,51,52), for instance by being connected to said translational transmission member (52) cooperating via a groove (36') and pin (52') with said driving slide(s) (36),
optionally said driving slide(s) (36) comprising a slide body (36‴) bearing a pair of arms (36ʺʺ) each delimiting a groove (36'), the arms (36ʺʺ) extending from the body (36‴) in parallel or substantially in parallel to the processing axis (30') along opposite sides of at least one of the first and second capsule handlers (10,20), for instance said groove (36') being delimited by a ridge or ledge (36'') projecting from the slide body (36‴) for example around said at least one of the first and second capsule handlers (10,20).

8. The machine of any preceding claim, wherein:
- the first and second capsule handlers (10,20) in their processing configuration delimit a capsule processing chamber (100) configured to enclose said capsule (5), optionally one capsule handler (10) of the first and second capsule handlers (10,20) forming a cavity (11) shaped to receive said capsule (5) and the other capsule handler (20) of the first and second capsule handlers (10,20) forming a lid (21) configured to close the cavity (11) in the processing configuration, the lid (21) being distant from the cavity (11) in the transfer configuration, e.g. such as to provide sufficient space (100') between the first and second capsule handlers (10,20) for said capsule (5) to be able to reach a position between the first and second capsule handlers (10,20) in the transfer configuration and/or to be evacuated from such position; and/or
- at least one handler (20) of the first and second capsule handlers (10,20) comprises or is associated with an inlet (22) for guiding a liquid carrier, e.g. water, to said capsule (5) when said capsule (5) is being centrifuged by rotation, optionally the inlet (22) being associated with a capsule inlet opener, e.g. an inlet piercing device (23), configured to open said capsule (5), for instance a capsule opener that has a conduit for guiding said liquid carrier from the inlet (22) into said capsule (5) and/or a capsule opener that has an outer face delimiting a passage for guiding said liquid carrier from the inlet into said capsule, optionally one handler (20) of the first and second handlers (10,20) comprising or being associated with both said inlet (22) and said outlet (24); and/or
- at least one handler (20) of the first and second capsule handlers (10,20) comprises or is associated with an outlet (24) for guiding said beverage from said capsule (5) when said capsule (5) is being centrifuged by rotation, optionally the outlet (24) being associated with a capsule outlet opener, e.g. an outlet piercing device (25), configured to open said capsule (5), for instance a capsule opener that has a conduit for guiding said beverage from said capsule into said outlet and/or a capsule opener that has an outer face delimiting a passage for guiding said beverage from said capsule into said outlet, optionally one handler (20) of the first and second handlers (10,20) comprising or being associated with both said inlet (22) and said outlet (24).

9. The machine of any preceding claim, wherein the capsule insertion passage (60) is covered by a lid or a gate when the first and second capsule handlers (10,20) are rotated for centrifugation, e.g. when the first and second capsule handlers (10,20) are in their capsule processing configuration, for instance the lid or gate being formed by a or said handle (50) configured to relatively move the first and second capsule handlers (10,20) between the capsule transfer and processing configurations.

10. The machine of claim 3 or any claim depending on claim 3, wherein the handler support device (30) is pivotally supported by the machine frame or housing (40) via a first bearing (41), such as a ball or roller bearing or a magnetic or plain bearing, and via a second bearing (42), such as a second ball or roller bearing or a magnetic or plain bearing, the first and second bearings (41,42) being located spaced apart along the processing axis (30'),
optionally the first bearing (41) being located on a side of the handler support device (30) that is closer to the first capsule handler (10) than to the second capsule handler (20), the second bearing (42) being located on a side of the support device (30) that is closer to the second capsule handler (20) than to the first capsule handler (10), the first and second bearings (41,42) being e.g. located at opposite ends of the support device (30).

11. The machine of claim 3 or any claim depending on claim 3, wherein the handler support device (30) has a substantially cylindrical shape extending along the processing axis (30') and surrounding at least partly the first and second capsule handlers (10,20), optionally the handler support device (30) delimiting one or two openings (39) configured for passing said capsule (5) into and/or out of the handler support device (30), e.g. via corresponding capsule inlet and/or outlet capsule passages (39',39"), for example by passing said capsule (5) transversally to the processing axis (30').

12. The machine of any preceding claim, which has a positioning device (30",40") configured to position at least one of the first and second capsule handlers (10,20) at a predetermined angular position about the processing axis (30') when the first and second capsule handlers (10,20) are in the capsule transfer configuration, for instance when rotation of the first and second capsule handlers (10,20) about the processing axis (30') is at a stop, optionally the positioning device (30",40") comprises at least one of:
- a mechanical position coupler, e.g. including a mechanical lock or stopper or break, such as a coupler that is uncoupled and/or deactivated during rotation of the first and second capsule handlers (10,20) about the processing axis (30'); and
- a magnetic position coupler, such as a magnetic coupler having a connector (40") stationary relative to the machine frame and/or housing (40), which stationary connector (40") is magnetically constrained with a connector (30") that is fixed to or comprised by at least one of the first and second capsule handlers (10,20) and the handler support device (30), optionally one connector (40") of the connectors (30",40") being a magnetic field generating element, e.g. a permanent magnet or an electromagnet or a permanent magnet with an electromagnet configured to neutralize the permanent magnet when the first and second capsule handlers (10,20) rotate about the processing axis (30'), and the other connector (30") of the connectors (30",40") comprising at least one of a ferromagnetic member, a permanent magnet and an electromagnet.

13. A system comprising a capsule processing machine (1) as defined in any preceding claim and a capsule (5) having a body containing an ingredient, the capsule (5) being handled by the capsule insertion guide(s) associated with the machine's capsule insertion passage (60), the rotatable portion (38) of the insertion guide(s) being configured to rotate with the machine's first and second capsule handlers (10,20) in their capsule processing configuration when the capsule (5) is centrifuged.

14. A method of preparing in a machine (1), as defined in any one of claim 1 to 12, a beverage from a capsule (5) having a body containing an ingredient, the method comprising:
- transferring the capsule (5) to the first and second capsule handlers (10,20) in their transfer configuration to receive the capsule (5) via the capsule insertion guide(s) (61) associated with the capsule insertion passage (60);
- bringing the first and second capsule handlers (10,20) into the capsule processing configuration; and
- centrifuging the capsule (5) handled by the first and second capsule handlers (10,20) that are rotated with the capsule insertion guide(s) (61) about the processing axis (30') and circulating the liquid into the capsule (5) to form the beverage.

15. A use of a capsule as the capsule (5) for:
- a machine as defined in any one of claims 1 to 12;
- implementing the system as defined in claim 13; or
- carrying out the method of claim 14,
wherein said capsule (5) is:
- transferred to the first and second capsule handlers (10,20) in their transfer configuration to receive the capsule (5) via the capsule insertion guide(s) (61) associated with the capsule insertion passage (60);
- supported by the first and second capsule handlers (10,20) in their capsule processing configuration; and
- centrifuged while being handled by the first and second capsule handlers (10,20) that are rotated with the capsule insertion guide(s) (61) about the processing axis (30') while the liquid is circulated into the capsule (5) to form the beverage.

## Patentansprüche

1. Kapselverarbeitungsmaschine (1) zum Zubereiten eines Getränks aus einer Kapsel (5), die einen Körper aufweist, der eine Zutat enthält, durch Zirkulieren einer Flüssigkeit in eine solche Kapsel (5) und zentrifugales Antreiben einer solchen Kapsel (5), umfassend:
- eine erste Kapselhandhabungseinrichtung (10) und eine zweite Kapselhandhabungseinrichtung (20), die relativ zueinander bewegbar sind von:
- einer Kapselübergabekonfiguration zum Aufnehmen der Kapsel (5) durch die erste und die zweite Kapselhandhabungseinrichtung (10, 20) und/oder Freigeben der Kapsel (5) aus der ersten und der zweiten Kapselhandhabungseinrichtung (10, 20); in
- eine Kapselverarbeitungskonfiguration zum Zentrifugieren der Kapsel (5) durch Drehung um eine Verarbeitungsachse (30') der ersten und der zweiten Kapselhandhabungseinrichtung (10, 20); und
- umgekehrt;
- einen Kapseleinsetzdurchgang (60), der mit einer oder mehreren Kapseleinsetzführungen (61) verknüpft ist, die konfiguriert sind, um die Kapsel (5) durch Führen eines hervorstehenden Kapselflansches (5') der Kapsel (5) in Richtung einer Kapselhalteposition in einem Raum (100') zwischen der ersten und der zweiten Kapselhandhabungseinrichtung (10, 20) in ihrer Übergabekonfiguration zu führen, wobei der Raum (100') beispielsweise mit einer Haltevorrichtung verknüpft ist, wie einem oder mehreren Anschlagelementen (38'), z. B. Anschlagelementen (38'), die durch die Einsetzführung(en) (61) ausgebildet oder daran befestigt sind, die konfiguriert sind, um die Kapsel in dem Raum (100') zu halten, bevor sie durch mindestens eine der ersten und der zweiten Kapselhandhabungseinrichtung (10, 20) gehalten werden, die sich relativ in Richtung der Kapselverarbeitungskonfiguration und/oder in diese bewegen,
- ein Maschinenrahmen und/oder ein -gehäuse (40), der/das stationär ist, wenn die erste und die zweite Kapselhandhabungseinrichtung (10, 20) für die Zentrifugation gedreht werden, und der/das die erste und die zweite Kapselhandhabungseinrichtung (10, 20) trägt,
wobei optional der Rahmen und/oder das Gehäuse:
- einen Boden umfasst oder daran befestigt ist, der konfiguriert ist, um auf einer Tragoberfläche außerhalb einer solchen Maschine (1) zu ruhen, wenn die erste und die zweite Kapselhandhabungseinrichtung (10, 20) für die Zentrifugation um die Verarbeitungsachse (30') gedreht werden, z. B. einer außenliegenden Tragoberfläche, die durch eine Tischplatte ausgebildet ist, wobei die Verarbeitungsachse (30') in einem Winkel relativ zu einem solchen Boden in dem Bereich von 0° bis 80°, beispielsweise von 0° bis 45°, wie von 0° bis 30°, z. B. von 0° bis 15°, typischerweise von im Wesentlichen 0° steht; und/oder
- einen Motor (2) trägt, der mit mindestens einer der ersten und der zweiten Kapselhandhabungseinrichtung (10, 20) verbunden ist, beispielsweise direkt oder über ein Getriebe (3) verbunden ist, wie mindestens eines von Riemen, z. B. Zahnriemen, Zahnrädern, z. B. Stirnrädern, und Verbindungsstangen,
**dadurch gekennzeichnet, dass** die Kapseleinsetzführung(en) (61) mindestens einen drehbaren Abschnitt (38) umfasst/umfassen, der relativ zu mindestens einer der ersten und der zweiten Kapselhandhabungseinrichtung (10, 20) stationär ist und sich damit dreht, wenn die erste und die zweite Kapselhandhabungseinrichtung (10, 20) für die Zentrifugation gedreht werden, wobei der drehbare Abschnitt (38) optional durch mindestens eine der ersten und der zweiten Kapselhandhabungseinrichtung (10, 20) ausgebildet oder daran montiert ist.

2. Maschine nach Anspruch 1, wobei die Kapseleinsetzführung(en) (61) einen nicht drehbaren Abschnitt (48) umfasst/umfassen, der relativ zu dem Maschinenrahmen und/oder -gehäuse (40) stationär ist, wenn die erste und die zweite Kapselhandhabungseinrichtung (10, 20) für die Zentrifugation gedreht werden, wobei der nicht drehbare Abschnitt (48) optional relativ zu dem Rahmen und/oder dem Gehäuse (40) stationär ist, wenn die erste und die zweite Kapselhandhabungseinrichtung (10, 20) relativ zwischen der Kapselübergabekonfiguration und der Kapselverarbeitungskonfiguration bewegt werden, wobei der nicht drehbare Abschnitt (48) z. B. durch den Maschinenrahmen und/oder das -gehäuse (40) ausgebildet oder daran montiert ist.

3. Maschine nach einem der vorstehenden Ansprüche, die eine Handhabungseinrichtungstragvorrichtung (30) zum Tragen der ersten und der zweiten Kapselhandhabungseinrichtung (10,20) umfasst, wobei die Handhabungseinrichtungstragvorrichtung (30) konfiguriert ist, um relativ zu der ersten und der zweiten Kapselhandhabungseinrichtung (10, 20) winkelfest zu sein und zu bleiben, und um sich damit um die Verarbeitungsachse (30') zu drehen, wenn die erste und die zweite Kapselhandhabungseinrichtung (10, 20) für die Zentrifugation gedreht werden, wobei die Handhabungseinrichtungstragvorrichtung (30) optional konfiguriert ist, um relativ zu der ersten und der zweiten Kapselhandhabungseinrichtung (10, 20) in ihrer Übergabekonfiguration winkelfest zu sein.

4. Maschine nach einem der vorstehenden Ansprüche, die einen Aktuator (50, 51, 52) umfasst, der konfiguriert ist, um die erste und/oder die zweite Kapselhandhabungseinrichtung (10, 20) zu betätigen, um die erste und die zweite Kapselhandhabungseinrichtung (10, 20) relativ zwischen der Kapselübergabe- und -verarbeitungskonfiguration zu bewegen, wobei der Aktuator (50, 51, 52) optional mit dem Maschinenrahmen und/oder -gehäuse (40) verbunden ist, um relativ dazu stationär zu bleiben, wenn die erste und die zweite Kapselhandhabungseinrichtung (10, 20) für die Zentrifugation gedreht werden,
wobei der Aktuator beispielsweise einen Motor oder einen Griff (50) umfasst, der auf einer Griffachse (51) schwenkbar angebracht ist, wobei der Motor oder der Griff (50) mit einem Translationsübertragungselement (52) zusammenwirkt, wie einem Aktuatorschlitten (52) und/oder einem Element (52), das durch den Motor oder den Griff (50) über eine Verbindung aus Nocken (53) und Nockenstößel (54) gesteuert wird, das zum relativen Bewegen der Kapselhandhabungseinrichtungen (10, 20) zwischen der Kapselübergabekonfiguration und der Kapselverarbeitungskonfiguration direkt oder indirekt mit der ersten und der zweiten Kapselhandhabungseinrichtung (10, 20) verbunden ist.

5. Maschine nach einem der vorstehenden Ansprüche, die eine Antriebsvorrichtung (31, 32, 32, 33, 34, 35, 36) umfasst, die mit der ersten und der zweiten Kapselhandhabungseinrichtung (10, 20) verbunden ist, um die Kapselhandhabungseinrichtungen (10, 20) relativ zwischen der Kapselübergabekonfiguration und der Kapselverarbeitungskonfiguration zu bewegen, wobei die Antriebsvorrichtung (31, 32, 32, 33, 34, 35, 36) optional:
- die Kapselhandhabungseinrichtungen (10, 20) in der Verarbeitungskonfiguration durch mindestens eines von einer Verriegelung, einem Reibungsanschlag und einem überzentrierten Hebel- oder Nockenmechanismus (37, 37') sichert; und/oder
- eines oder mehrere umfasst von: Hebeln (31, 32), z. B. Hebeln, die in einer Kniehebelanordnung um Schwenkachsen (33, 34, 35) schwenkbar montiert sind; Zahnrädern, z. B. Stirnrädern und/oder Zahnstangen, z. B. Stirnzahnstangen; Nocken und Nockenstößeln; Riemen, z. B. Zahnriemen; und Antriebsschlitten (36).

6. Maschine nach Anspruch 5, wenn abhängig von Anspruch 3, wobei die Antriebsvorrichtung (31, 32, 32, 33, 34, 35, 36) die erste Kapselhandhabungseinrichtung (10) und die zweite Kapselhandhabungseinrichtung (20) über die Handhabungseinrichtungstragvorrichtung (30) verbindet, wobei beispielsweise die erste Kapselhandhabungseinrichtung oder die zweite Kapselhandhabungseinrichtung (20) relativ zu der Handhabungseinrichtungstragvorrichtung (30) stationär ist.

7. Maschine nach Anspruch 5 oder 6, wenn abhängig von Anspruch 3 oder 4, wobei die Antriebsvorrichtung (31, 32, 33, 34, 35, 36) den/die Antriebsschlitten (36) und optional ein oder mehrere Übertragungselemente (31, 32, 33, 34, 35) umfasst, die den/die Antriebsschlitten (36) mit der ersten und der zweiten Kapselhandhabungseinrichtung (10, 20) verbinden, um die Kapselhandhabungseinrichtungen (10, 20) relativ zwischen der Kapselübergabekonfiguration und der Kapselverarbeitungskonfiguration zu bewegen, wobei der/die Antriebsschlitten (36) durch den Aktuator (50, 51, 52) betätigt wird/werden, beispielsweise durch Verbundenwerden mit dem Translationsübertragungselement (52), das über eine Nut (36') und einen Stift (52') mit dem/den Antriebsschlitten (36) zusammenwirkt,
wobei der/die Antriebsschlitten (36) optional einen Schlittenkörper (36‴) umfasst/umfassen, der ein Paar Arme (36ʺʺ) lagert, die jeweils eine Nut (36') begrenzen, wobei sich die Arme (36ʺʺ) von dem Körper (36‴) parallel oder im Wesentlichen parallel zu der Verarbeitungsachse (30') entlang gegenüberliegender Seiten von mindestens einer der ersten und der zweiten Kapselhandhabungseinrichtung (10, 20) erstrecken, wobei beispielsweise die Nut (36') durch einen Grat oder einen Absatz (36") begrenzt wird, der von dem Schlittenkörper (36"') zum Beispiel um mindestens eine der ersten und der zweiten Kapselhandhabungseinrichtung (10, 20) herum hervorsteht.

8. Maschine nach einem der vorstehenden Ansprüche, wobei:
- die erste und die zweite Kapselhandhabungseinrichtung (10, 20) in ihrer Verarbeitungskonfiguration eine Kapselverarbeitungskammer (100) begrenzen, die konfiguriert ist, um die Kapsel (5) zu umschließen, wobei eine Kapselhandhabungseinrichtung (10) der ersten und der zweiten Kapselhandhabungseinrichtung (10, 20) optional einen Hohlraum (11) ausbildet, der geformt ist, um die Kapsel (5) aufzunehmen, und die andere Kapselhandhabungseinrichtung (20) der ersten und der zweiten Kapselhandhabungseinrichtung (10, 20) einen Deckel (21) ausbildet, der konfiguriert ist, um den Hohlraum (11) in der Verarbeitungskonfiguration zu verschließen, wobei der Deckel (21) in der Übergabekonfiguration von dem Hohlraum (11) entfernt ist, z. B. um ausreichend Raum (100') zwischen der ersten und der zweiten Kapselhandhabungseinrichtung (10, 20) bereitzustellen, damit die Kapsel (5) in der Lage ist, in der Übergabekonfiguration eine Position zwischen der ersten und der zweiten Kapselhandhabungseinrichtung (10, 20) zu erreichen und/oder aus einer solchen Position evakuiert zu werden; und/oder
- mindestens eine Handhabungseinrichtung (20) der ersten und der zweiten Kapselhandhabungseinrichtung (10, 20) einen Einlass (22) zum Führen eines flüssigen Trägers, z. B. Wasser, zu der Kapsel (5) umfasst oder damit verknüpft ist, wenn die Kapsel (5) durch Drehung zentrifugiert wird, wobei der Einlass (22) optional mit einem Kapseleinlassöffner, z. B. einer Einlassdurchstechvorrichtung (23), verknüpft ist, der konfiguriert ist, um die Kapsel (5) zu öffnen, beispielsweise einem Kapselöffner, der eine Leitung zum Führen des flüssigen Trägers von dem Einlass (22) in die Kapsel (5) aufweist, und/oder einem Kapselöffner, der eine Außenfläche aufweist, die einen Durchgang zum Führen des flüssigen Trägers von dem Einlass in die Kapsel begrenzt, wobei eine Handhabungseinrichtung (20) der ersten und der zweiten Handhabungseinrichtung (10, 20) optional sowohl den Einlass (22) als auch den Auslass (24) umfasst oder damit verknüpft ist; und/oder
- mindestens eine Handhabungseinrichtung (20) der ersten und der zweiten Kapselhandhabungseinrichtung (10, 20) einen Auslass (24) zum Führen des Getränks aus der Kapsel (5) umfasst oder damit verknüpft ist, wenn die Kapsel (5) durch Drehung zentrifugiert wird, wobei der Auslass (24) optional mit einem Kapselauslassöffner verknüpft ist, z. B. einer Auslassdurchstechvorrichtung (25), der konfiguriert ist, um die Kapsel (5) zu öffnen, beispielsweise einem Kapselöffner, der eine Leitung zum Führen des Getränks aus der Kapsel in den Auslass aufweist, und/oder einem Kapselöffner, der eine Außenfläche aufweist, die einen Durchgang zum Führen des Getränks aus der Kapsel in den Auslass begrenzt, wobei eine Handhabungseinrichtung (20) der ersten und der zweiten Kapselhandhabungseinrichtung (10, 20) optional sowohl den Einlass (22) als auch den Auslass (24) umfasst oder damit verknüpft ist.

9. Maschine nach einem der vorstehenden Ansprüche, wobei der Kapseleinsetzdurchgang (60) durch einen Deckel oder einen Schieber abgedeckt ist, wenn die erste und die zweite Kapselhandhabungseinrichtung (10, 20) für die Zentrifugation gedreht werden, z. B. wenn die erste und die zweite Kapselhandhabungseinrichtung (10, 20) in ihrer Kapselverarbeitungskonfiguration sind, wobei beispielsweise der Deckel oder der Schieber durch einen oder den Griff (50) ausgebildet ist, der konfiguriert ist, um die erste und die zweite Kapselhandhabungseinrichtung (10, 20) relativ zwischen der Kapselübergabe- und der Kapselverarbeitungskonfiguration zu bewegen.

10. Maschine nach Anspruch 3 oder einem von Anspruch 3 abhängigen Anspruch, wobei die Handhabungseinrichtungstragvorrichtung (30) über ein erstes Lager (41), wie ein Kugel- oder Rollenlager oder ein Magnet- oder Gleitlager, und über ein zweites Lager (42), wie ein zweites Kugel- oder Rollenlager oder ein Magnet- oder Gleitlager, durch den Maschinenrahmen oder das -gehäuse (40) schwenkbar getragen wird, wobei das erste und das zweite Lager (41, 42) entlang der Verarbeitungsachse (30') beabstandet gelegen sind,
wobei das erste Lager (41) optional auf einer Seite der Handhabungseinrichtungstragvorrichtung (30) gelegen ist, die näher an der ersten Kapselhandhabungseinrichtung (10) als an der zweiten Kapselhandhabungseinrichtung (20) liegt, wobei das zweite Lager (42) auf einer Seite der Tragvorrichtung (30) gelegen ist, die näher an der zweiten Kapselhandhabungseinrichtung (20) als an der ersten Kapselhandhabungseinrichtung (10) liegt, wobei das erste und das zweite Lager (41, 42) z. B. an gegenüberliegenden Enden der Tragvorrichtung (30) gelegen sind.

11. Maschine nach Anspruch 3 oder einem von Anspruch 3 abhängigen Anspruch, wobei die Handhabungseinrichtungstragvorrichtung (30) eine im Wesentlichen zylindrische Form aufweist, die sich entlang der Verarbeitungsachse (30') erstreckt und mindestens teilweise die erste und die zweite Kapselhandhabungseinrichtung (10, 20) umgibt, wobei die Handhabungseinrichtungstragvorrichtung (30) optional eine oder zwei Öffnungen (39) begrenzt, die zum Weitergeben der Kapsel (5) in die Handhabungseinrichtungstragvorrichtung (30) und/oder aus ihr heraus konfiguriert sind, z. B. über entsprechende Kapseleinlass- und/oder Auslasskapseldurchgänge (39', 39"), zum Beispiel durch Weitergeben der Kapsel (5) quer zu der Verarbeitungsachse (30').

12. Maschine nach einem der vorstehenden Ansprüche, die eine Positionierungsvorrichtung (30", 40") aufweist, die konfiguriert ist, um mindestens eine der ersten und der zweiten Kapselhandhabungseinrichtung (10, 20) in einer zuvor bestimmten Winkelposition um die Verarbeitungsachse (30') zu positionieren, wenn die erste und die zweite Kapselhandhabungseinrichtung (10, 20) in der Kapselübergabekonfiguration sind, beispielsweise wenn die Drehung der ersten und der zweiten Kapselhandhabungseinrichtung (10, 20) um die Verarbeitungsachse (30') gestoppt ist, wobei die Positionierungsvorrichtung (30", 40") optional mindestens eines umfasst von:
- einer mechanischen Positionskopplung, z. B. einschließlich einer mechanischen Verriegelung oder eines Anschlags oder einer Unterbrechung, wie eine Kopplung, die während der Drehung der ersten und der zweiten Kapselhandhabungseinrichtung (10, 20) um die Verarbeitungsachse (30') entkoppelt und/oder deaktiviert wird; und
- einem magnetischen Positionskoppler, wie einem magnetischen Koppler, der einen Verbinder (40") aufweist, der relativ zu dem Maschinenrahmen und/oder -gehäuse (40) stationär ist, wobei der stationäre Verbinder (40") mit einem Verbinder (30") magnetisch eingeschränkt ist, der an mindestens einer der ersten und der zweiten Kapselhandhabungseinrichtung (10, 20) und der Handhabungseinrichtungstragvorrichtung (30) befestigt ist oder dadurch umfasst ist, wobei ein Verbinder (40") der Verbinder (30", 40") optional ein magnetfelderzeugendes Bauteil ist, z. B. ein Permanentmagnet oder ein Elektromagnet oder ein Permanentmagnet mit einem Elektromagneten, der konfiguriert ist, um den Permanentmagneten zu neutralisieren, wenn sich die erste und die zweite Kapselhandhabungseinrichtung (10, 20) um die Verarbeitungsachse (30') drehen, und der andere Verbinder (30") der Verbinder (30", 40") mindestens ein ferromagnetisches Element, einen Permanentmagneten oder einen Elektromagneten umfasst.

13. System, das eine Kapselverarbeitungsmaschine (1) nach einem der vorstehenden Ansprüche und eine Kapsel (5) umfasst, die einen Körper aufweist, der eine Zutat enthält, wobei die Kapsel (5) durch die Kapseleinsetzführung(en) gehandhabt wird, die mit dem Kapseleinsetzdurchgang (60) der Maschine verknüpft ist/sind, wobei der drehbare Abschnitt (38) der Einsetzführung(en) konfiguriert ist, um sich mit der ersten und der zweiten Kapselhandhabungseinrichtung (10, 20) der Maschine in ihrer Kapselverarbeitungskonfiguration zu drehen, wenn die Kapsel (5) zentrifugiert wird.

14. Verfahren zum Zubereiten eines Getränks in einer Maschine (1) nach einem der Ansprüche 1 bis 12 aus einer Kapsel (5), die einen Körper aufweist, der eine Zutat enthält, das Verfahren umfassend:
- Übergeben der Kapsel (5) an die erste und die zweite Kapselhandhabungsvorrichtung (10, 20) in ihrer Übergabekonfiguration, um die Kapsel (5) über die Kapseleinsetzführung(en) (61) aufzunehmen, die mit dem Kapseleinsetzdurchgang (60) verknüpft ist/sind;
- Bringen der ersten und der zweiten Kapselhandhabungseinrichtung (10, 20) in die Kapselverarbeitungskonfiguration; und
- Zentrifugieren der Kapsel (5), die durch die erste und die zweite Kapselhandhabungseinrichtung (10, 20) gehandhabt wird, die mit der/den Kapseleinsetzführung(en) (61) um die Verarbeitungsachse (30') gedreht werden, und Zirkulieren der Flüssigkeit in die Kapsel (5), um das Getränk auszubilden.

15. Verwendung einer Kapsel als die Kapsel (5) für/zum:
- eine Maschine nach einem der Ansprüche 1 bis 12;
- Implementieren des Systems nach Anspruch 13; oder
- Durchführen des Verfahrens nach Anspruch 14,
wobei die Kapsel (5) ist:
- an die erste und die zweite Kapselhandhabungseinrichtung (10, 20) in ihrer Übergabekonfiguration übergeben, um die Kapsel (5) über die Kapseleinsetzführung(en) (61) aufzunehmen, die mit dem Kapseleinsetzdurchgang (60) verknüpft ist/sind;
- durch die erste und die zweite Kapselhandhabungseinrichtung (10, 20) in ihrer Kapselverarbeitungskonfiguration getragen; und
- zentrifugiert, während sie durch die erste und die zweite Kapselhandhabungseinrichtung (10, 20) gehandhabt wird, die mit der/den Kapseleinsetzführung(en) (61) um die Verarbeitungsachse (30') gedreht werden, während die Flüssigkeit in die Kapsel (5) zirkuliert, um das Getränk auszubilden.

## Revendications

1. Machine de traitement de capsule (1) permettant de préparer une boisson à partir d'une capsule (5) ayant un corps contenant un ingrédient, en faisant circuler un liquide dans une telle capsule (5) et en entraînant une telle capsule (5) par centrifugation, comprenant :
- un premier dispositif de manipulation de capsule (10) et un second dispositif de manipulation de capsule (20) qui sont mobiles l'un par rapport à l'autre à partir :
- d'une configuration de transfert de capsule permettant de recevoir ladite capsule (5) par les premier et second dispositifs de manipulation de capsule (10, 20) et/ou de libérer ladite capsule (5) des premier et second dispositifs de manipulation de capsule (10, 20) ; jusqu'à
- une configuration de traitement de capsule permettant de centrifuger ladite capsule (5) par rotation autour d'un axe de traitement (30') des premier et second dispositifs de manipulations de capsule (10, 20) ; et
- vice versa ;
- un passage d'insertion de capsule (60) associé à un ou plusieurs guides d'insertion de capsule (61) conçus pour guider ladite capsule (5) en guidant une collerette de capsule saillante (5') de ladite capsule (5) vers une position de maintien de capsule dans un espace (100') entre les premier et second dispositifs de manipulation de capsule (10, 20) dans leur configuration de transfert, par exemple l'espace (100') étant associé à un dispositif de maintien, tel qu'un ou plusieurs éléments de butée (38'), par exemple des éléments de butée (38') formés par le ou les guides d'insertion (61) ou fixés sur ceux-ci, conçus pour maintenir ladite capsule dans l'espace (100') avant qu'elle ne soit maintenue par au moins l'un des premier et second dispositifs de manipulation de capsule (10, 20) se déplaçant relativement vers et/ou dans la configuration de traitement de capsule,
- un châssis et/ou boîtier de machine (40) qui est stationnaire lorsque les premier et second dispositifs de manipulation de capsule (10, 20) sont amenés à tourner pour une centrifugation et qui soutient les premier et second dispositifs de manipulation de capsule (10, 20),
facultativement le châssis et/ou boîtier :
- comprenant ou étant fixé à une partie inférieure conçue pour reposer sur une surface de support externe à une telle machine (1) lorsque les premier et second dispositifs de manipulation de capsule (10, 20) sont amenés à tourner autour de l'axe de traitement (30') pour une centrifugation, par exemple, une surface de support externe formée par un plateau de table, l'axe de traitement (30') étant à un angle par rapport à une telle partie inférieure compris dans la plage de 0° à 80°, par exemple de 0° à 45°, tel que de 0° à 30°, par exemple de 0° à 15°, typiquement de sensiblement 0° ; et/ou
- soutenant un moteur (2) qui est relié à au moins l'un des premier et second dispositifs de manipulation de capsule (10, 20), par exemple relié directement ou par l'intermédiaire d'une transmission (3), telle qu'au moins l'un parmi des courroies, par exemple des courroies dentées, des engrenages, par exemple des engrenages droits, et des bielles,
**caractérisé en ce que** le ou les guides d'insertion de capsule (61) comprennent au moins une partie rotative (38) qui est stationnaire par rapport à au moins l'un des premier et second dispositifs de manipulation de capsule (10, 20) et tourne avec eux lorsque les premier et second dispositifs de manipulation de capsule (10, 20) sont amenés à tourner pour une centrifugation, facultativement la partie rotative (38) étant formée par au moins l'un des premier et second dispositifs de manipulation de capsule (10, 20) ou étant assemblée à ceux-ci.

2. Machine selon la revendication 1, dans laquelle le ou les guides d'insertion de capsule (61) comprennent une partie non rotative (48) qui est stationnaire par rapport au châssis et/ou boîtier de machine (40) lorsque les premier et second dispositifs de manipulation de capsule (10, 20) sont amenés à tourner pour une centrifugation, facultativement la partie non rotative (48) étant stationnaire par rapport au châssis et/ou boîtier (40) lorsque les premier et second dispositifs de manipulation de capsule (10, 20) sont relativement déplacés entre la configuration de transfert de capsule et la configuration de traitement de capsule, par exemple la partie non rotative (48) étant formée par le châssis et/ou boîtier de machine (40) ou étant assemblée à celui-ci.

3. Machine selon l'une quelconque revendication précédente, qui comprend un dispositif de support de dispositif de manipulation (30) permettant de soutenir les premier et second dispositifs de manipulations de capsule (10, 20), le dispositif de support de dispositif de manipulation (30)
étant conçu pour être et rester angulairement fixe par rapport aux premier et second dispositifs de manipulations de capsule (10, 20) et pour tourner avec eux autour de l'axe de traitement (30') lorsque les premier et second dispositifs de manipulation de capsule (10, 20) sont amenés à tourner pour une centrifugation, facultativement le dispositif de support de dispositif de manipulation (30) étant conçu pour être angulairement fixe par rapport aux premier et second dispositifs de manipulation de capsule (10, 20) dans leur configuration de transfert.

4. Machine selon l'une quelconque revendication précédente, qui comprend un actionneur (50, 51, 52) qui est configuré pour actionner les premier et/ou second dispositifs de manipulation de capsule (10, 20) afin de déplacer relativement les premier et second dispositifs de manipulation de capsule (10, 20) entre les configurations de transfert et de traitement de capsule, facultativement l'actionneur (50, 51, 52) étant relié au châssis et/ou boîtier de machine (40) de manière à rester stationnaire par rapport à ceux-ci lorsque les premier et second dispositifs de manipulation de capsule (10, 20) sont amenés à tourner pour une centrifugation,
par exemple, l'actionneur comprenant un moteur ou une poignée (50) montée pivotante sur un axe de poignée (51), le moteur ou la poignée (50) coopérant avec un élément de transmission de translation (52), tel qu'une glissière d'actionneur (52) et/ou un élément (52) commandé par le moteur ou la poignée (50) par l'intermédiaire d'une connexion à came (53) et à galet suiveur (54), directement ou indirectement reliée aux premier et second dispositifs de manipulation de capsule (10, 20) pour déplacer relativement les dispositifs de manipulation de capsule (10, 20) entre la configuration de transfert de capsule et la configuration de traitement de capsule.

5. Machine selon l'une quelconque revendication précédente, qui comprend un dispositif d'entraînement (31, 32, 32, 33, 34, 35, 36) connecté aux premier et second dispositifs de manipulation de capsule (10, 20) pour déplacer relativement les dispositifs de manipulation de capsule (10, 20) entre la configuration de transfert de capsule et la configuration de traitement de capsule, facultativement le dispositif d'entraînement (31, 32, 32, 33, 34, 35, 36) :
- fixant solidement les dispositifs de manipulation de capsule (10, 20) dans la configuration de traitement par au moins l'un parmi un verrou, une butée à friction et un mécanisme de came ou de levier à détente brusque (37,37') ; et/ou
- comprenant un ou plusieurs parmi : des leviers (31,32), par exemple des leviers assemblés de manière pivotante autour de l'axe de pivotement (33,34,35) dans un arrangement à grenouillère ; des engrenages, par exemple des engrenages droits, et/ou des crémaillères, par exemple des crémaillères droites ; des cames et des galets suiveurs ; des courroies, par exemple des courroies dentées ; et des glissières d'entraînement (36).

6. Machine selon la revendication 5, lorsqu'elle dépend de la revendication 3, dans laquelle le dispositif d'entraînement (31, 32, 32, 33, 34, 35, 36) relie le premier dispositif de manipulation de capsule (10) et le second dispositif de manipulation de capsule (20) par l'intermédiaire du dispositif de support de dispositif de manipulation (30), par exemple le premier dispositif de manipulation de capsule ou le second dispositif de manipulation de capsule (20) étant stationnaire par rapport au dispositif de support de dispositif de manipulation (30).

7. Machine selon la revendication 5 ou 6 lorsqu'elle dépend de la revendication 3 ou 4, dans laquelle le dispositif d'entraînement (31, 32, 33, 34, 35, 36) comprend ladite ou lesdites glissières d'entraînement (36), et facultativement un ou plusieurs éléments de transmission (31, 32, 33, 34, 35) reliant la ou les glissières d'entraînement (36) aux premier et second dispositifs de manipulation de capsule (10, 20), pour déplacer de manière relative les dispositifs de manipulation de capsule (10, 20) entre la configuration de transfert de capsule et la configuration de traitement de capsule, la ou les glissières d'entraînement (36) étant actionnées par ledit actionneur (50, 51, 52), par exemple en étant reliées audit élément de transmission de translation (52) coopérant par l'intermédiaire d'une rainure (36') et d'une tige (52') avec ladite ou lesdites glissières d'entraînement (36),
facultativement, ladite ou lesdites glissières d'entraînement (36) comprennent un corps de glissière (36"') portant une paire de bras (36"") délimitant chacun une rainure (36'), les bras (36"") s'étendant à partir du corps (36"') parallèlement ou sensiblement parallèlement à l'axe de traitement (30') le long de côtés opposés d'au moins l'un des premier et second dispositifs de manipulation de capsule (10, 20), par exemple ladite rainure (36') étant délimitée par une crête ou un rebord (36") faisant saillie à partir du corps de glissière (36"'), par exemple autour dudit au moins l'un des premier et second dispositifs de manipulation de capsule (10, 20).

8. Machine selon l'une quelconque revendication précédente, dans laquelle :
- les premier et second dispositifs de manipulation de capsule (10, 20) dans leur configuration de traitement délimitent une chambre de traitement de capsule (100) conçue pour enfermer ladite capsule (5), facultativement un dispositif de manipulation de capsule (10) des premier et second dispositifs de manipulation de capsule (10, 20) formant une cavité (11) profilée pour recevoir ladite capsule (5) et l'autre dispositif de manipulation de capsule (20) des premier et second dispositifs de manipulation de capsule (10, 20) formant un couvercle (21) conçu pour fermer la cavité (11) dans la configuration de traitement, le couvercle (21) étant éloigné de la cavité (11) dans la configuration de transfert, par exemple de manière à fournir un espace (100') suffisant entre les premier et second dispositifs de manipulation de capsule (10, 20) pour que ladite capsule (5) puisse atteindre une position entre les premier et second dispositifs de manipulation de capsule (10, 20) dans la configuration de transfert et/ou être évacuée de cette position ; et/ou
- au moins un dispositif de manipulation (20) des premier et second dispositifs de manipulation de capsule (10, 20) comprend ou est associé à une entrée (22) permettant de guider un support liquide, par exemple de l'eau, vers ladite capsule (5) lorsque ladite capsule (5) est en cours de centrifugation par rotation, l'entrée (22) étant facultativement associée à un dispositif d'ouverture d'entrée de capsule, par exemple un dispositif de perçage d'entrée (23), conçu pour ouvrir ladite capsule (5), par exemple un dispositif d'ouverture de capsule qui a un conduit permettant de guider ledit véhicule liquide de l'entrée (22) dans ladite capsule (5) et/ou un dispositif d'ouverture de capsule qui a une face externe délimitant un passage permettant de guider ledit véhicule liquide de l'entrée dans ladite capsule, facultativement un dispositif de manipulation (20) des premier et second dispositifs de manipulation (10, 20) comprenant ou étant associé à la fois à ladite entrée (22) et à ladite sortie (24) ; et/ou
- au moins un dispositif de manipulation (20) des premier et second dispositifs de manipulation de capsule (10, 20) comprend ou est associé à une sortie (24) permettant de guider ladite boisson de ladite capsule (5) lorsque ladite capsule (5) est en cours de centrifugation par rotation, facultativement la sortie (24) étant associée à un dispositif d'ouverture de sortie de capsule, par exemple un dispositif de perçage de sortie (25), conçu pour ouvrir ladite capsule (5), par exemple un dispositif d'ouverture de capsule qui a un conduit permettant de guider ladite boisson de ladite capsule dans ladite sortie et/ou un dispositif d'ouverture de capsule qui a une face externe délimitant un passage permettant de guider ladite boisson de ladite capsule dans ladite sortie, facultativement un dispositif de manipulation (20) des premier et second dispositifs de manipulation (10, 20) comprenant ou étant associé à la fois à ladite entrée (22) et à ladite sortie (24).

9. Machine selon l'une quelconque revendication précédente, dans laquelle le passage d'insertion de capsule (60) est recouvert par un couvercle ou une porte lorsque les premier et second dispositifs de manipulation de capsule (10, 20) sont amenés à tourner pour une centrifugation, par exemple lorsque les premier et second dispositifs de manipulation de capsule (10, 20) sont dans leur configuration de traitement de capsule, par exemple le couvercle ou la porte étant formé par une ou ladite poignée (50) conçue pour déplacer relativement les premier et second dispositifs de manipulation de capsule (10, 20) entre les configurations de transfert et de traitement de capsule.

10. Machine selon la revendication 3 ou l'une quelconque revendication dépendant de la revendication 3, dans laquelle le dispositif de support de dispositif de manipulation (30) est soutenu de manière pivotante par le châssis ou boîtier de machine (40) par l'intermédiaire d'un premier palier (41), tel qu'un roulement à billes ou à rouleaux ou un palier magnétique ou lisse, et par l'intermédiaire d'un second palier (42), tel qu'un second roulement à billes ou à rouleaux ou un palier magnétique ou lisse, les premier et second paliers (41,42) étant situés à distance le long de l'axe de traitement (30'),
facultativement, le premier palier (41) étant situé sur un côté du dispositif de support de dispositif de manipulation (30) qui est plus proche du premier dispositif de manipulation de capsule (10) que du second dispositif de manipulation de capsule (20), le second palier (42) étant situé sur un côté du dispositif de support (30) qui est plus proche du second dispositif de manipulation de capsule (20) que du premier dispositif de manipulation de capsule (10), les premier et second paliers (41,42) étant par exemple situés au niveau d'extrémités opposées du dispositif de support (30).

11. Machine selon la revendication 3 ou l'une quelconque revendication dépendant de la revendication 3, dans laquelle le dispositif de support de dispositif de manipulation (30) a une forme sensiblement cylindrique s'étendant le long de l'axe de traitement (30') et entourant au moins partiellement les premier et second dispositifs de manipulation de capsule (10, 20), facultativement le dispositif de support de dispositif de manipulation (30) délimitant une ou deux ouvertures (39) conçues pour faire passer ladite capsule (5) dans le dispositif de support de dispositif de manipulation (30) et/ou hors de celui-ci, par exemple par l'intermédiaire de passages de capsule d'entrée et/ou de sortie (39',39") correspondants, par exemple en faisant passer ladite capsule (5) transversalement à l'axe de traitement (30').

12. Machine selon l'une quelconque revendication précédente, qui a un dispositif de positionnement (30",40") configuré pour positionner au moins l'un des premier et second dispositifs de manipulation de capsule (10, 20) à une position angulaire prédéterminée autour de l'axe de traitement (30') lorsque les premier et second dispositifs de manipulation de capsule (10, 20) sont dans la configuration de transfert de capsule, par exemple lorsque la rotation des premier et second dispositifs de manipulation de capsule (10, 20) autour de l'axe de traitement (30') est à l'arrêt, facultativement le dispositif de positionnement (30",40") comprend au moins l'un parmi :
- un dispositif mécanique d'accouplement de position, comportant par exemple un verrou, une butée ou une rupture mécanique, tel qu'un dispositif d'accouplement qui est découplé et/ou désactivé pendant la rotation des premier et second dispositifs de manipulation de capsule (10, 20) autour de l'axe de traitement (30') ; et
- un dispositif magnétique d'accouplement de position, tel qu'un dispositif magnétique d'accouplement ayant un connecteur (40") stationnaire par rapport au châssis et/ou boîtier de machine (40), lequel connecteur stationnaire (40") étant magnétiquement contraint avec un connecteur (30") qui est fixé à ou compris par au moins l'un des premier et second dispositifs de manipulation de capsule (10, 20) et le dispositif de support de dispositif de manipulation (30), facultativement un connecteur (40") des connecteurs (30",40") étant un élément générateur de champ magnétique, par exemple un aimant permanent ou un électro-aimant ou un aimant permanent avec un électro-aimant configuré pour neutraliser l'aimant permanent lorsque les premier et second dispositifs de manipulation de capsule (10, 20) tournent autour de l'axe de traitement (30'), et l'autre connecteur (30") des connecteurs (30",40") comprenant au moins un élément ferromagnétique, un aimant permanent et un électro-aimant.

13. Système comprenant une machine de traitement de capsule (1) selon l'une quelconque revendication précédente et une capsule (5) ayant un corps contenant un ingrédient, la capsule (5) étant manipulée par le ou les guides d'insertion de capsule associés au passage d'insertion de capsule (60) de la machine, la partie rotative (38) du ou des guides d'insertion étant conçue pour tourner avec les premier et second dispositifs de manipulation de capsule (10, 20) de la machine dans leur configuration de traitement de capsule lorsque la capsule (5) est centrifugée.

14. Procédé de préparation dans une machine (1), selon l'une quelconque des revendications 1 à 12, d'une boisson à partir d'une capsule (5) ayant un corps contenant un ingrédient, le procédé comprenant :
- le transfert de la capsule (5) vers les premier et second dispositifs de manipulation de capsule (10, 20) dans leur configuration de transfert pour recevoir la capsule (5) par l'intermédiaire du ou des guides d'insertion de capsule (61) associés au passage d'insertion de capsule (60) ;
- le fait d'amener les premier et second dispositifs de manipulation de capsule (10, 20) dans la configuration de traitement de capsule ; et
- la centrifugation de la capsule (5) manipulée par les premier et second dispositifs de manipulation de capsule (10, 20) qui sont amenés à tourner avec le ou les guides d'insertion de capsule (61) autour de l'axe de traitement (30') et la circulation du liquide dans la capsule (5) pour former la boisson.

15. Utilisation d'une capsule en tant que capsule (5) pour :
- une machine selon l'une quelconque des revendications 1 à 12 ;
- la mise en œuvre du système selon la revendication 13 ; ou
- la réalisation du procédé selon la revendication 14,
dans laquelle ladite capsule (5) est :
- transférée aux premier et second dispositifs de manipulation de capsule (10, 20) dans leur configuration de transfert pour recevoir la capsule (5) par l'intermédiaire du ou des guides d'insertion de capsule (61) associés au passage d'insertion de capsule (60) ;
- soutenue par les premier et second dispositifs de manipulation de capsule (10, 20) dans leur configuration de traitement de capsule ; et
- centrifugée tout en étant manipulée par les premier et second dispositifs de manipulation de capsule (10, 20) qui sont amenés à tourner avec le ou les guides d'insertion de capsule (61) autour de l'axe de traitement (30') pendant que le liquide amené à circuler dans la capsule (5) pour former la boisson.
